**Europäisches Patentamt**

**European Patent Office**

**Office européen des brevets**

(19)

(11) Veröffentlichungsnummer: **0 491 270 A2**

# EUROPÄISCHE PATENTANMELDUNG

(12)

(21) Anmeldenummer: **91121215.7**

(22) Anmeldetag: **11.12.91**

(51) Int. Cl.5: **A45C 5/02**

(30) Priorität: **19.12.90 DE 9017103 U**

(43) Veröffentlichungstag der Anmeldung:
**24.06.92 Patentblatt 92/26**

(84) Benannte Vertragsstaaten:
**DE ES FR GB IT**

(71) Anmelder: **Mannesmann Kienzle GmbH
Heinrich-Hertz-Strasse 45
W-7730 Villingen-Schwenningen(DE)**

(72) Erfinder: **Säger, Benjamin, Dipl.-Ing. (FH)
Brunnenstrasse 26
W-7730 Villingen-Schwenningen(DE)**

(54) Anordnung zum Verbinden zweier Gehäuseteile eines Einbaugehäuses.

(57) Es wird eine schraubenlose, von außen lösbare Verbindung zweier Gehäuseteile mit umlaufenden Seitenwänden, die stirnseitig zusammengefügt werden, vorgeschlagen, wobei die Verbindungsmittel in besonders einfacher Weise bündig mit den Seitenwänden ausgebildet sind. Im einzelnen sind am einen Gehäuseteil (3) Riegel (31, 32) zusammen mit Führungsstegen (45, 46, 47 und 48) ausgebildet, während an dem anderen Gehäuseteil (2) mit Durchbrüchen (33 und 34) für die Riegelnasen (49, 50) versehene Lappen angeformt sind. Als zusätzliche Sicherungsmaßnahme für die Riegel-Lappen-Verbindungen dient eine zwischen den Gehäuseteilen (2, 3) vorgesehene Falzverbindung (37, 38).

FIG. 2

Die Erfindung betrifft eine Anordnung zum Verbinden zweier Gehäuseteile eines Einbaugehäuses mit umlaufenden Seitenwänden, die stirnseitig zusammengefügt werden.

In den Fällen, in denen Gehäuse beispielsweise von Anzeige- und Registriergeräten lediglich eine Schutzfunktion gegen Verschmutzung und Berührung erfüllen sollen und eine tragende Funktion nur insoweit vorgesehen ist, als in dem Gehäuse die Funktionselemente des Gerätes als funktionsfertige und selbsttragende Aggregate auf einem Boden oder auf bodenständigen Säulen befestigt werden, können die Festigkeitsanforderungen verringert und relativ dünne Wandstärken in Kauf genommen werden.

Insbesondere bei Einbaugeräten, bei denen es darauf ankommt, eine tragende Verbindung zwischen den Funktionsaggregaten innerhalb des Gehäuses und den Vorkehrungen zur Befestigung des Gehäuses am Einbauort zu schaffen, können die nicht im Kraftfluß liegenden Gehäusebereiche zweier Gehäuseschalen bzw. eines mit einer Haube oder einem Rahmen versehenen Bodens sehr einfach und dünnwandig gestaltet werden, was bei spritzgießtechnisch hergestellten Kunststoffgehäusen zu erheblich verringerten Werkzeug- und Materialkosten führt und die Standzeiten der Spritzgußformen erhöht.

Um trotz Materialeinsparung und Dünnwandigkeit der Gehäuseteile eine ausreichende Steifigkeit der Seitenwände zu erhalten, ist es zweckmäßig, hohe Seitenwände zu vermeiden, die Seitenwände auf zwei Gehäuseteile zu verteilen und stumpf- bzw. stirnseitig zusammenzufügen. Dabei ist es nicht nur aus ästhetischen Gründen sondern auch wegen des Einbaus des Gerätes beispielsweise in eine Instrumentenkonsole eines Kraftfahrzeuges von Vorteil, daß die Seitenwände bündig zusammengefügt sind. Selbstverständlich müssen auch die Verbindungstechnik und die Verbindungsmittel für die lösbar miteinander verbindbaren Gehäuseteile der Forderung nach Serienmontage, nach Materialeinsparung und formtechnischer Einfachheit entsprechen.

Die Aufgabe der vorliegenden Erfindung besteht somit darin, Verbindungsmittel für das geschilderte Gehäusekonzept zu schaffen, die den vorstehend genannten Forderungen gerecht werden, unmittelbar an den Gehäuseteilen ausgebildet sind und hohe Funktionssicherheit auch bei erheblichen thermischen und schwingungsbedingten mechanischen Belastungen bieten.

Die Lösung der Aufgabe sieht vor, daß an den Seitenwänden Riegel und den Riegeln zugeordnete Freisparungen derart ausgebildet sind, daß die den Riegelnasen abgekehrten Rückenflächen der Riegel mit den Innenflächen der Seitenwände eines Gehäuseteils im wesentlichen bündig sind und daß sich in dem anderen Gehäuseteil den Riegeln zugeordnete Bereiche geringerer Wandstärke mit für die Riegelnasen vorgesehenen Durchbrüchen befinden.

Ein bevorzugtes Ausführungsbeispiel ist dadurch gekennzeichnet, daß die Riegel durch an der Außenseite des betreffenden Gehäuseteils angebrachte Aussparungen freigestellt sind und daß an dem anderen Gehäuseteil bündig mit der Außenfläche der jeweiligen Seitenwand den Aussparungen entsprechende Lappen mit den Riegelnasen zugeordneten Durchbrüchen angeformt sind, ferner dadurch daß die Seitenwände jeweils mit einem Falz versehen sind, derart daß der Falz an dem einen Gehäuseteil auf der Seite der Riegel, an dem anderen Gehäuseteil auf der Seite der Lappen ausgebildet ist.

Die Erfindung bietet den Vorteil, daß eine schraubenlose, von außen lösbare Verbindung für zwei Gehäuseteile mit innen und außen bündigen Seitenwandflächen gechaffen werden kann. Damit wird die erfindungsgemäße Lösung nicht nur ästhetischen Belangen und der Forderung einer problemlosen Einbaufähigkeit gerecht, sondern sie stellt eine formtechnische Optimierung dar. Die Gehäuseteile und die Mittel zum Verbinden der Gehäuseteile erfordern keine seitlich überstehenden Konturen, insbesondere keine nach innen abstehenden Konturen, die Hinterschnitte erforderlich machen, d. h. sie lassen sich auf besonders einfache Weise entformen, mit dem Ergebnis, daß der Werkzeugaufwand gering ist.

Die Erfindung mit sozusagen innerhalb des Querschnitts einer Wand ausgebildeten Verbindungs- bzw. Verriegelungsmitteln gestattet ferner, daß ohne Mehraufwand mehrere Riegelverbindungen an ein und derselben Wand ausgebildet werden können und somit unter Beibehaltung der bereits genannten Vorzüge ein mehrfaches "Zusammenheften" zweier Seitenwände von Gehäuseteilen ermöglicht wird, was sich insbesondere bei den angestrebten dünnen Gehäusewänden, die sich unter thermischer Beanspruchung leicht wölben und dabei auseinanderbiegen können, besonders vorteilhaft auswirkt. In diesem Sinne ist aber auch das gegenseitige Übergreifen der Riegelverbindungen und der Falzverbindung wirksam, d. h. auf die Gehäusewände seitlich einwirkende Kräfte werden über die Verbindungsmittel auf beide Gehäuseteile verteilt und ein Auseinanderklaffen der miteinander verbundenen Gehäuseteile wird vermieden.

Die glattflächige Ausbildung der Seitenwände des Gehäuses gestattet einen exakt rechteckigen oder quadratischen Einbauquerschnitt des Gehäuses, wobei die rechtwinklig zueinander stehenden Seitenwände der Gehäuseteile nicht unmittelbar aufeinanderstoßend ausgebildet sind sondern Wandverbindungen, beispielsweise sickenförmige, nach innen gewölbte Wandteile, vorgesehen sind, die die Gehäuseecken freisparen. Diese Ausführungsform bietet den Vorteil, daß vorzugsweise an dem Gehäuseteil, das die Funktionsaggregate trägt, noch innerhalb des Einbauquerschnitts Konsolen zur Befestigung des Gehäuses ausgebildet werden können. Selbstverständlich lassen sich die Konsolen auch innerhalb der Seitenwände, beispielsweise auch an zwei gegenüberliegenden Seitenwänden, durch geeignete Einbuchtungen ausbilden. Dadurch würde zwar zusätzlich eine höhere Steifigkeit der betreffenden Seitenwände erreicht, der innerhalb des Gerätes zur Verfügung stehende Raum aber verringert.

Im folgenden sei die Erfindung anhand der beigefügten Zeichnungen näher erläutert.

Es zeigen

Fig. 1 eine Perspektivdarstellung des erfindungsgemäßen Einbaugehäuses,

Fig. 2 Seitenansichten der beiden das Einbaugehäuse bildenden Gehäuseteile in einer Montagestellung unmittelbar vor dem Zusammenfügen,

Fig. 3 einen Schnitt durch einen am einen Gehäuseteil angeformten Lappen gemäß der Schnittlinie A in Fig. 2,

Fig. 4 einen Schnitt durch einen am anderen Gehäuseteil angeformten Riegel gemäß der Schnittlinie B in Fig. 2,

Fig. 5 eine Draufsicht auf einen an einer Seitenwand ausgebildeten Riegel gemäß der Pfeilrichtung D in Fig. 2,

Fig. 6 einen Schnitt durch eine plombierte Riegelverbindung gemäß der Schnittlinie c in Fig. 1 und

Fig. 7 eine Draufsicht auf das Einbaugehäuse.

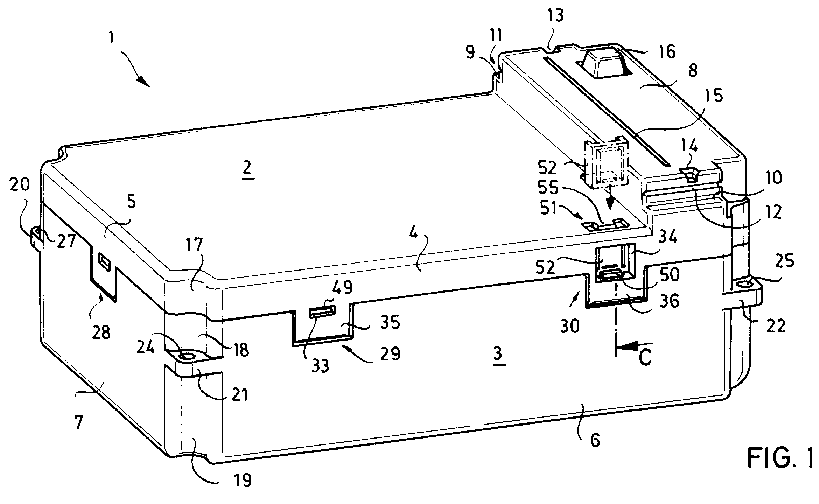

Die Fig. 1 zeigt ein Einbaugehäuse 1 bestehend aus zwei Gehäusebauteilen 2 und 3 mit umlaufenden Seitenwänden, von denen in Fig. 1 jeweils zwei, 4 und 5 bzw. 6 und 7, sichtbar sind. Das eine Gehäuseteil 3 dient bei dem dargestellten Einbaugehäuse 1 der Aufnahme von Funktionsaggregaten des betreffenden Gerätes, in diesem Falle eines Registriergerätes, das andere Gehäuseteil 2 stellt eine Abdeckung dar, an welcher ein Podest 8 ausgebildet ist, das beim Einbau des Gerätes beispielsweise in ein Armaturenbrett eines Kraftfahrzeugs in eine Aussparung des Armaturenbretts von der Rückseite her eingreift und durch eine nicht dargestellte Frontblende, mit der Anpassungen an die Gestaltung des Armaturenbretts vorgenommen werden können, abdeckbar ist. Zur Halterung der Frontblende an dem Gehäuseteil 2 dienen Ausschnitte 9 und 10, Kerben 11 und 12 sowie Einschnitte 13 und 14. Ein Schlitz 15 ist für die Eingabe und Ausgabe der verwendeten Registrier- bzw. Druckträger vorgesehen. Mit 16 ist im Falle einer Einfachstausführung des Gerätes eine Taste bezeichnet, mittels der die Ausgabe eines Druckträgers steuerbar ist. Selbstverständlich kann je nach Einbausituation das Gehäuseteil 2 in anderer Weise gestaltet, beispielsweise rahmenförmig ausgebildet sein. Auch kann das Gerät zusätzlich mit einer Anzeige ausgerüstet sein oder ausschließlich ein Anzeigegerät darstellen, wobei in dem abdeckenden Gehäuseteil 2 ein geeigneter Ausschnitt vorgesehen sein muß.

Wie ferner aus Fig. 1 ersichtlich ist, sind an beiden Gehäuseteilen 2 und 3 im Eckbereich der Seitenwände Einbuchtungen vorgesehen, von denen stellvertretend für die übrigen die einer Ecke des Einbaugehäuses 1 zugeordneten mit 17, 18 und 19 bezeichnet sind. Die Einbuchtungen 18 und 19 sparen an dem die Funktionsaggregate des Gerätes aufnehmenden Gehäuseteil 3 Konsolen aus, die mit 20, 21, 22 und 23 bezeichnet sind. In den Konsolen vorgesehene Bohrungen 24, 25, 26 und 27 dienen dem Durchführen von Befestigungsschrauben oder ortsfesten Gewindestiften.

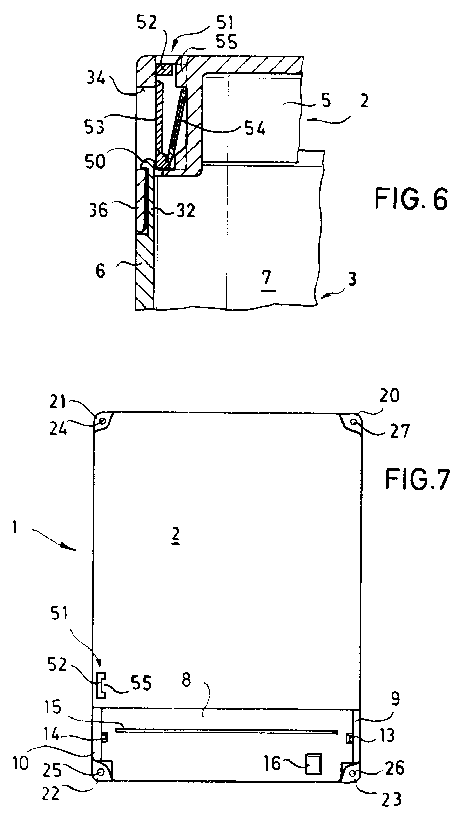

Wie aus der Draufsicht Fig. 7 ersichtlich ist, liegen die Konsolen 20, 21, 22, 23 innerhalb rechteckiger oder quadratischer Querschnittskonturen des Einbaugehäuses 1, dessen glattflächige Seitenwände durch die bündig aneinander stoßenden Seitenwände 4 und 6, 5 und 7 sowie diesen gegenüberliegenden, jedoch nicht bezeichneten Seitenwänden der Gehäuseteile 2 und 3 gebildet sind. Mit 28, 29 und 30 sind in Fig. 1 Riegelverbindungen bezeichnet, mit denen die Gehäuseteile 2 und 3 von außen lösbar miteinander verbunden sind. Erfindungsgemäß sind die Riegelverbindungen derart gestaltet, daß ihre Elemente weder außen, noch innen von den Seitenwänden des Einbaugehäuses 1 abstehen.

Im folgenden werden die den beiden Seitenwänden 4 und 6 zugeordneten Riegelverbindungen näher beschrieben. Selbstverständlich sind zum Befestigen der Gehäuseteile 2 und 3 auch an den nicht in Ansicht dargestellten Seitenwänden Riegelverbindungen vorgesehen. Bei relativ langen Seitenwänden sind auch mehr als zwei Riegelverbindungen denkbar.

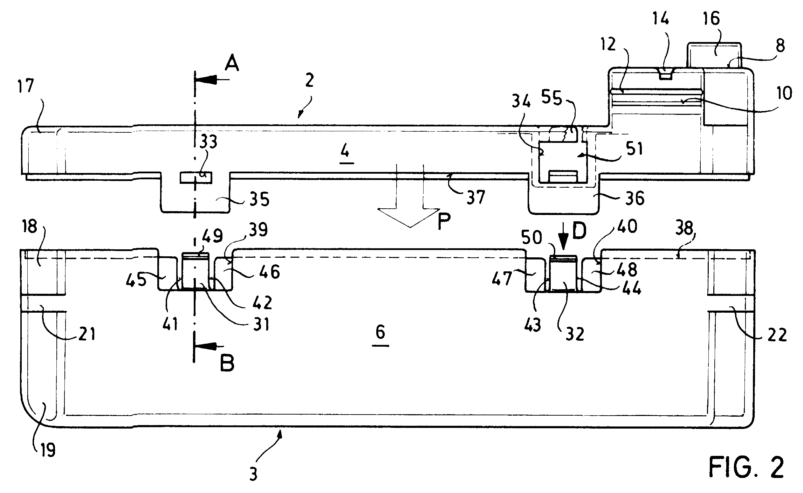

Die Fig. 2 zeigt die beiden Gehäuseteile 2 und 3 in einer Montagestellung vor dem Zusammenfügen in Pfeilrichtung P. Beim Zusammenfügen gehen die an der Seitenwand 6 ausgebildeten Riegel 31 und 32 in Eingriff mit Durchbrüchen 33 und 34, die in an der Seitenwand 4 des Gehäuseteils 2 angeformten Lappen 35 und 36 ausgebildet sind. Der Durchbruch 34 ist aufgrund einer zusätzlichen Funktion, die im folgenden noch beschrieben wird, größer ausgebildet als der Durchbruch 33. Mit 37 und 38 ist jeweils ein an dem betreffenden Gehäuseteil 2 bzw. 3 umlaufend ausgebildeter Falz bezeichnet, der am Gehäuseteil 2 lediglich durch die Lappen 35, 36, am Gehäuseteil 3 durch die Riegel 31, 32 unterbrochen ist.

Wie ferner aus der Fig. 2 ersichtlich ist, sind die Riegel 31 und 32 durch Aussparungen 39 und 40 in der Seitenwand 6 derart freigestellt, daß beidseitig der Riegel 31 und 32 für deren Federungsfähigkeit erforderliche Schlitze 41, 42, 43 und 44 sowie Überdehnungen der Riegel 31 und 32 beim Zusammenfügen der Gehäuseteile 2 und 3 vermeidende Führungsstege 45, 46, 47 und 48 ausgebildet sind. Die Bezugszeichen 49 und 50 bezeichnen die mit den Durchbrüchen 33, 34 in den Lappen 35 und 36 zusammenwirkenden Riegelnasen. Der in der Seitenwand 4 vorgesehene, vergrößerte Durchbruch 34 führt zu einer Kammer 51, in die eine Plombe 52 einsetzbar ist.

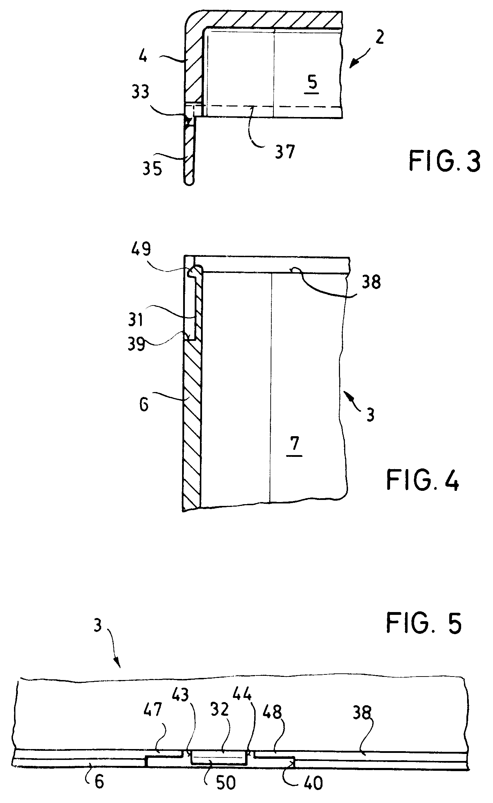

Die Schnitte Fig. 3 und Fig. 4 sowie die Draufsicht Fig. 5 machen deutlich, daß die Elemente einer der Riegelverbindungen 28, 29, 30 sozusagen innerhalb des Querschnitts der relativ dünnen Seitenwände der Gehäuseteile 2 und 3 und somit einer Seitenwand des Einbaugehäuses 1 ausgebildet sind. Die Draufsicht Fig. 5 zeigt in Verbindung mit Fig. 2 anschaulich das gegenseitige Zusammenfügen von Lappen und Führungsstegen einerseits und der Falzverbindung andererseits.

Mit der Fig. 6 ist eine Lösung dargestellt, die es gestattet, eine der erfindungsgemäßen Riegelverbindungen und somit das Gerät zu plombieren. Die verwendete, rahmenförmig ausgebildete Plombe 52 ist mit einer in geeigneter Weise freigesparten und mit einer Sollbruchstelle zum Rahmen versehenen Wand 53 ausgerüstet, die den Durchbruch 34, wenn die Plombe 52 gesetzt ist, abdeckt. Eine ebenfalls mittels eines Filmscharniers an dem Rahmen der Plombe 52 angeformte Platte 54 dient als Rastklinke. Beim Einschieben der Plombe 52 in die Kammer 51 rastet die Platte 54 hinter einer am Gehäuseteil 2 vorgesehenen Nase 55 ein und ist somit nur noch durch Eindrücken der Wand 53 lösbar.

Der Vollständigkeit halber sei noch erwähnt, daß für eine Verwendung, bei der eine Lösbarkeit der Riegelverbindungen nicht zwingend erforderlich ist, anstelle der den Riegelnasen zugeordneten Durchbrüche von außen unzugängliche Aussparungen vorgesehen sein können. Es ist ferner denkbar, die Riegel über die durch den Rand des betreffenden Gehäuseteils gebildete Ebene hinausragen zu lassen und in der Seitenwand des anderen Gehäuseteils geeignete Aussparungen vorzusehen oder die Überstände von Lappen und Riegeln gleichmäßig auf beide Gehäuseteile zu verteilen.

**Patentansprüche**

1. Anordnung zum Verbinden zweier Gehäuseteile eines Einbaugehäuses mit umlaufenden Seitenwänden, die stirnseitig zusammengefügt werden,
dadurch gekennzeichnet,
daß an den Seitenwänden Riegel und den Riegeln zugeordnete Freisparungen derart ausgebildet sind, daß die den Riegelnasen abgekehrten Rückenflächen der Riegel mit den Innenflächen der Seitenwände eines Gehäuseteils (3) im wesentlichen bündig sind und
daß sich in dem anderen Gehäuseteil (2) den Riegeln zugeordnete Bereiche geringerer Wandstärke mit für die Riegelnasen vorgesehenen Durchbrüchen befinden.

2. Anordnung nach Anspruch 1,
dadurch gekennzeichnet,
daß die Riegel (31, 32) durch an der Außenseite des betreffenden Gehäuseteils (3) angebrachte Aussparungen (39, 40) freigestellt sind und
daß an dem anderen Gehäuseteil (2) bündig mit der Außenfläche der jeweiligen Seitenwand (4) den Aussparungen (39, 40) entsprechende Lappen (35, 36) mit den Riegelnasen (49, 50) zugeordneten Durchbrüchen (33, 34) angeformt sind.

3. Anordnung nach Anspruch 1,
dadurch gekennzeichnet,
daß die Riegel (31, 32) unterhalb einer durch den äußeren Rand der Seitenwände (6, 7) bestimmten Ebene ausgebildet sind.

4. Anordnung nach Anspruch 2,
dadurch gekennzeichnet,
daß die Tiefe der Aussparungen (39, 40) quer zur Seitenwand (6) durch beiderseits der Riegel (31, 32) ausgebildete und mit der Innenfläche der Seitenwand (6) bündige Führungsstege (45, 46, 47, 48) begrenzt ist.

5. Anordnung nach Anspruch 1,
dadurch gekennzeichnet,
daß die Seitenwände (4, 5, 6, 7) jeweils mit einem Falz (37, 38) versehen sind, derart daß der Falz (38) an dem einen Gehäuseteil (3) auf der Seite der Riegel (31, 32), an dem anderen Gehäuseteil (2) auf der Seite der Lappen (35, 36) ausgebildet ist.

6. Anordnung nach Anspruch 1,
dadurch gekennzeichnet,
daß wenigstens einem Riegel (32) des Einbaugehäuses (1) eine den Riegel (32) hintergreifende und mit dem Einbaugehäuse (1) rastend verbindbare Plombe (52) zugeordnet ist.

7. Einbaugehäuse nach Anspruch 1,

dadurch gekennzeichnet,

daß an den Seitenwänden (4, 5, 6, 7) der Gehäuseteile (2, 3) Einbuchtungen (17, 18, 19) vorgesehen sind und

daß an einem Gehäuseteil (3) zwischen den Einbuchtungen (18, 19) Konsolen (20, 21, 22, 23) mit der Befestigung des Einbaugehäuses (1) dienenden Bohrungen (24, 25, 26, 27) ausgebildet sind.

FIG. 1

EP 0 491 270 A2

FIG. 2

FIG. 3

FIG. 4

FIG. 5

FIG. 6

FIG.7